**Europäisches Patentamt**

**European Patent Office**

**Office européen des brevets**

(11) Numéro de publication: **0 336 787**
**A1**

## (12) DEMANDE DE BREVET EUROPEEN

(21) Numéro de dépôt: **89400522.2**

(22) Date de dépôt: **24.02.89**

(51) Int. Cl.4: **C 01 G 3/00**
**H 01 L 39/24, H 01 L 39/12**

(30) Priorité: **09.03.88 FR 8803020**

(43) Date de publication de la demande:
**11.10.89 Bulletin 89/41**

(84) Etats contractants désignés:
**AT BE CH DE ES FR GB GR IT LI LU NL SE**

(71) Demandeur: **RHONE-POULENC CHIMIE**
**25, quai Paul Doumer**
**F-92408 Courbevoie Cédex (FR)**

(72) Inventeur: **Dubois, Bertrand**
**1, allée des Sycomores**
**F-45100 Orleans (FR)**

**Odier, Philippe**
**107, rue du Désert**
**F-45560 Saint Denis en Val (FR)**

(74) Mandataire: **Dubruc, Philippe et al**
**RHONE-POULENC INTERSERVICES Service Brevets**
**Chimie 25, quai Paul-Doumer**
**F-92408 Courbevoie Cédex (FR)**

(54) **Procédé de fabrication de matériaux supraconducteurs et produits ainsi obtenus.**

(57) L'invention a trait à un procédé de préparation d'une poudre fine supraconductrice essentiellement à base d'au moins une terre rare, d'au moins un alcalino-terreux, d'au moins un métal de transition et d'oxygène, caractérisé en ce qu'il consiste à traiter thermiquement un aérosol contenant, sous la forme de sels organiques et/ou inorganiques et/ou sous la forme d'hydroxydes, ladite terre rare, ledit alcalino-terreux et ledit métal de transition dans un rapport correspondant à la stoechiométrie de la composition supraconductrice désirée.

Elle concerne également les poudres supraconductrices susceptibles d'être obtenues par ledit procédé.

EP 0 336 787 A1

Bundesdruckerei Berlin

**Description**

## PROCEDE DE FABRICATION DE MATERIAUX SUPRACONDUCTEURS ET PRODUITS AINSI OBTENUS

La présente invention a trait au domaine des matériaux supraconducteurs.

On sait que la supraconductivité se caractérise entre autre par la disparition de toute résistance électrique dans un corps porté à très basse température.

Jusqu'à un passé récent, l'état supraconducteur dans certains matériaux n'apparaissait qu'en-dessous d'une température seuil, dite "température critique", généralement proche du zéro absolu. Une telle contrainte a constitué à l'évidence un frein sérieux au développement sur une grande échelle de toutes les applications pratiques potentielles pouvant découler de la supraconductivité.

Or, depuis peu, des recherches ont permis de mettre en évidence de nouveaux matériaux qui présentent des propriétés supraconductrices à plus hautes températures, c'est-à-dire des températures s'étalant de 70 à 90°K, voire plus.

Ces matériaux sont pour la plupart à base de terres rares, d'alcalino-terreux, de métaux de transition et d'oxygène. Plus spécifiquement, les systèmes étudiés les plus prometteurs semblent être ceux à base d'yttrium et/ou lanthane et/ou d'erbium, de baryum ou/de strontium et/ou de calcium, de cuivre et/ou éventuellement d'autres métaux de transition, et d'oxygène.

La formulation $Y Ba_2 Cu_3 O_{7-x}$ ($0 \leq x \leq 0,5$) constitue un exemple particulièrement remarquable au sein de ces systèmes.

La méthode de synthèse généralement décrite dans la littérature pour aboutir à ces matériaux repose sur une réaction en phase solide, à hautes températures (1 000° C), entre des oxydes et/ou des sels contenant un anion volatil (par exemple le carbonate) des éléments correspondants, ces derniers composés se présentant sous forme de poudres.

Toutefois, un tel procédé présente plusieurs inconvénients sérieux.

D'une part, il est d'un contrôle délicat et il en résulte généralement la formation de phases intermédiaires parasites conduisant à des inhomogénéités au sein du matériau. Ces inhomogénéités, non supraconductrices, modifient la composition de la phase majoritaire et abaissent en conséquence la valeur du courant critique admissible ou peuvent même rendre la céramique elle-même non supraconductrice.

D'autre part, il conduit à des poudres dont l'aptitude à la mise en forme et au frittage peut paraître insuffisante, notamment en ce qui concerne les densités à cru susceptibles d'être obtenues et les densités finales mesurées après frittage. Ce problème peut être notamment relié à la morphologie non contrôlée des poudres de départ.

Or, au niveau de certaines applications pratiques, seule l'utilisation des produits frittés supraconducteurs présente un intérêt réel.

Il en découle donc a priori la nécessité de disposer tout d'abord de poudres supraconductrices parfaitement homogènes en taille et en compositions, et présentant de bonnes aptitudes au frittage.

La présente invention a donc pour but de résoudre les problèmes ci-dessus et de proposer des moyens simples, efficaces et de mise en oeuvre aisée, pour obtenir de manière fiable et reproductible des poudres supraconductrices fines et homogènes présentant une excellente aptitude au frittage, et susceptibles de conduire par frittage à des matériaux frittés supraconducteurs de haute densité.

On a maintenant trouvé, et il s'agit là d'un des premiers objets de la présente invention, que l'on peut obtenir des poudres supraconductrices à la fois fines, homogènes et facilement frittables au moyen du procédé de préparation selon l'invention, lesdites poudres étant du type de celles comprenant au moins une terre rare, au moins un alcalino-terreux, au moins un métal de transition et de l'oxygène, et ledit procédé étant caractérisé en ce qu'il consiste à traiter thermiquement un aérosol contenant, sous la forme de sels organiques et/ou inorganiques et/ou sous la forme d'hydroxydes, ladite terre rare, ledit alcalino-terreux et ledit métal de transition dans un rapport correspondant à la stoechiométrie de la composition supraconductrice désirée.

Dans l'exposé qui suit de la présente invention, on entend par aérosol tout système de fines gouttelettes en dispersion dans un gaz, la phase liquide de l'aérosol contenant donc les précurseurs organiques et/ou inorganiques de la composition supraconductrice désirée.

Cette phase liquide est généralement aqueuse ; éventuellement, il pourrait être utilisé un autre solvant que l'eau, par exemple un alcool, à la condition nécessaire bien entendu que lesdits précurseurs soient solubles dans ce solvant.

Un aérosol selon l'invention peut être obtenu classiquement en procédant à l'atomisation, c'est à dire à la transformation en une multitude de fines gouttelettes, d'une solution initiale contenant les précurseurs de la poudre supraconductrice désirée ; la phase liquide de l'aérosol possède alors la même composition que la solution précurseur initiale.

On entend également, dans l'exposé qui suit, par terre rare d'une part tout élément du Tableau Périodique dont le numéro atomique est compris, inclusivement, entre 57 et 71, et d'autre part l'yttrium qui, par convention, est assimilé ici à une terre rare.

Les terres rares particulièrement préférées pour la mise en oeuvre du procédé selon l'invention sont l'yttrium, le lanthane et l'erbium.

D'autre part, les alcalino-terreux utilisables dans le présent procédé sont principalement le calcium, le baryum et le strontium.

Enfin, concernant les métaux de transition, on opérera de préférence avec le cuivre, mais tout autre métal de transition peut éventuellement convenir.

Le choix des éléments au sein des familles ci-dessus se fera bien entendu en fonction de la nature et de la composition de la poudre supraconductrice que l'on désire obtenir.

On notera d'ores et déjà que le procédé selon l'invention s'applique particulièrement bien à la fabrication des systèmes supraconducteurs du type Y-Ba-Cu-O ; ces systèmes ont été étudiés notamment dans un article paru dans le Journal of American Chemical Society, 1987, 109, 2528-2530.

De même, les proportions entre les divers éléments au sein de la phase liquide de l'aérosol (gouttelettes) sont ajustées classiquement en fonction de la stoechiométrie désirée dans le produit final, celle-ci devant naturellement correspondre à l'obtention des propriétés supraconductrices.

Pratiquement, l'ajustement stoechiométrique se fait lors de la préparation de la solution précurseur initiale destinée à constituer l'aérosol, comme indiqué précédemment.

Selon l'invention, la terre rare, l'alcalino-terreux et le métal de transition sont introduits dans la solution initiale précurseur de l'aérosol sous la forme d'un de leurs sels et/ou d'un hydroxyde, ce sel et/ou cet hydroxyde devant être substantiellement soluble dans la phase solvante. Il peut être éventuellement nécessaire de modifier le pH de ladite solution initiale par ajout, selon le cas, soit d'acide, notamment d'acide acétique et/ou nitrique et/ou citrique, soit de base, comme l'ammoniac, et ceci dans le but d'augmenter la solubilité et/ou la stabilité des sels et/ou hydroxydes précurseurs dans ladite solution.

Selon un mode préféré de mise en oeuvre du procédé selon l'invention, la terre rare, l'alcalino-terreux et le métal de transition sont introduits dans la solution initiale uniquement sous la forme de sels, identiques ou différents.

Les sels inorganiques particulièrement préférés sont ceux qui se décomposent sans difficulté lors du traitement thermique ultérieur, c'est à dire sans libérer d'anions indésirables qu'il pourrait être difficile d'éliminer par la suite ; à titre de sels inorganiques convenant tout à fait bien, on peut ainsi citer les nitrates et les carbonates.

Les sels organiques particulièrement préférés pour la mise en oeuvre du procédé selon l'invention sont les sels d'acides aliphatiques saturés, tels que par exemple les formiates, les acétates et les proprionates ; les acétates conviennent particulièrement bien.

Encore plus spécifiquement, les solutions initiales particulièrement préférées dans la présente invention sont les suivantes :
- celles pour lesquelles tous les sels précurseurs sont des acétates en solution dans une phase aqueuse acidifiée à l'acide acétique
- celles pour lesquelles les sels précurseurs, indifféremment choisis parmi les nitrates, les acétates ou les carbonates, sont en solution dans une phase aqueuse acidifiée à l'acide citrique
- celles dans lesquelles l'alcalino-terreux et le métal de transition se présentent sous la forme d'acétates, et la terre rare sous la forme de nitrate, en solution dans une phase aqueuse, éventuellement acidifiée par de l'acide acétique.

Concernant l'atomisation de la solution précurseur initiale, elle peut être réalisée au moyen de tout pulvérisateur connu en soi, par exemple par une buse de pulvérisation du type pomme d'arrosoir ou autre. Toutefois, certains pulvérisateurs peuvent se révéler insuffisants pour l'obtention de gouttelettes à la fois très fines et très homogènes au niveau de la distribution de leurs tailles.

C'est pourquoi il est avantageux selon l'invention d'utiliser certains pulvérisateurs bien spécifiques, tels que les atomiseurs pneumatiques ou les atomiseurs ultrasoniques.

Selon un mode préférentiel de réalisation de l'invention on utilise un atomiseur ultrasonique ; ce type d'atomiseur est en effet particulièrement bien adapté pour réaliser de manière parfaitement reproductible des aérosols constitués de très fines gouttelettes sphériques homogènes en taille.

Ce type d'atomiseur est décrit notamment par R.J. LANG dans un article intitulé "Ultrasonic Atomisation of Liquids" (J.ACOUST Soc. Am., Vol. 34, n° 1, page 6-8, 1962).

Selon l'invention, le diamètre moyen des gouttelettes de l'aérosol peut être compris entre 0,5 micron et 6 microns, et plus préférentiellement entre 1 et 4 microns. Comme indiqué dans l'article précité, on règle la taille moyenne desdites gouttelettes en jouant indépendamment ou simultanément sur la fréquence d'excitation du nébuliseur et/ou la densité de la solution et/ou sa tension superficielle.

Les gouttelettes formées sont alors prises en charge par un gaz vecteur. Ce gaz peut être par exemple de l'azote, de l'air ou de l'oxygène.

L'aérosol passe alors dans un ou plusieurs fours pour subir un traitement thermique.

Selon un mode avantageux de réalisation de l'invention, le traitement thermique consiste à chauffer l'aérosol à une température au moins égale à 700°C, de préférence au moins égale à 850°C, mais dans tous les cas inférieure à 1000°C.

On remarque en effet qu'à des températures inférieures à 700°C, la phase supraconductrice désirée n'est obtenue que partiellement, ce qui nécessite la mise en oeuvre d'un post traitement thermique qui peut avoir tendance à affecter l'homogénéité morphologique des poudres désirées. Par contre, à des températures supérieures à 700°C, il est possible d'obtenir directement et totalement la phase supraconductrice désirée.

La durée du traitement thermique peut varier de 1 seconde à 30 minutes, et de préférence de 5 à 15 secondes.

Le traitement thermique est conduit sous atmosphère d'air ou sous un mélange air/oxygène, mais de préférence sous air.

Ce traitement thermique peut éventuellement, si nécessaire, être suivi d'un second traitement thermique, dit traitement de recuit, et ceci dans le but de parfaire la cristallisation des particules constituant la poudre supraconductrice.

Le traitement de recuit est alors conduit sous oxygène à une température comprise entre 4000 et 1000°C, de préférence à une température se situant aux environs de 850°C. La durée du recuit peut varier de une à plusieurs heures, de préférence de une à deux heures.

A la suite du traitement thermique selon l'invention, éventuellement suivi d'un recuit, on récupère une poudre fine supraconductrice constituée de particules quasiment sphériques ayant substantiellement conservé l'homogénéité morphologique des gouttelettes initiales.

Ces particules présentent une granulométrie macroscopique s'étalant de 0,1 à 3 microns environ, en étant centrée avec un très faible écart-type standart (inférieur à 1,4) sur un diamètre moyen qui, suivant la distribution initiale des gouttelettes, se situe entre 0,1 et 2 microns, et de préférence entre 0,4 et 1,5 microns.

Ces particules sont constituées de cristallites élémentaires de taille comprise entre 100 et 500 nanomètres, de préférence située aux environs de 250 nm (déterminée par microscopie électronique à balayage). Ces cristallites sont mâclés.

D'autre part, la surface spécifique des poudres obtenues par le procédé selon l'invention est de l'ordre de 15 $m^2/g$ (mesurée, après compaction, à l'aide d'un porosimètre à mercure).

Ces poudres présentent le phénomène de supraconductivité que l'on peut observer par l'apparition d'un diamagnétisme au dessous de 93 K due à l'effet MEISSNER.

Les poudres supraconductrices selon l'invention se caractérisent en outre par des propriétés tout à fait remarquables et surprenantes vis à vis de leur aptitude au frittage.

Ces poudres supraconductrices présentent en effet la propriété de pouvoir donner, après frittage, des matériaux frittés dont la densité finale est supérieure ou égale à 95 % de la densité théorique du matériau considéré.

Pratiquement, il est possible de mettre en forme sous pressage une poudre supraconductrice selon l'invention jusqu'à obtenir un produit présentant une densité égale à 60 % de la densité théorique du matériau considéré, puis d'opérer un frittage sans charge, sous atmosphère d'oxygène, à une température comprise entre 900° et 1000°C, pendant un temps compris généralement entre 2 et 10 heures, suivi d'un refroidissement lent jusqu'à 20° C, de manière à aboutir finalement à un matériau fritté supraconducteur dont la densité soit supérieure ou égale à 95 % de la densité théorique du matériau considéré.

Plus spécifiquement, les caractéristiques des poudres supraconductrices selon l'invention, au regard de leur aptitude au frittage, sont déterminées de la façon suivante :

la poudre est tout d'abord pastillée, avec ou sans liant, sous une pression uniaxiale de 4,8 $t/cm^2$ (480 MPa) jusqu'à obtenir une densité en cru égale à 60 % de la densité théorique du matériau désiré, puis frittée pendant 3 heures à une température de 910°C ; on mesure alors la densité du produit fritté. Dans tous les cas on observe une densité finale supérieure à 95 % de la densité théorique du matériau considéré.

D'autre part, on observe que le produit fritté obtenu présente des propriétés supraconductrices.

Des exemples concrets illustrant l'invention vont maintenant être donnés.

EXEMPLE 1

Cet exemple illustre l'invention dans le cadre de la préparation d'une poudre supraconductrice de formule : Y - Ba$_2$ - Cu$_3$ - O$_{7-x}$ ($0 \leqq x \leqq 0,2$).

On prépare une solution précurseur consistant en une solution aqueuse à base d'acétate de cuivre (0,2028 mole/l), d'acétate de baryum (0,1352 mole/l) et de nitrate d'yttrium (0,0676 mole/l).

Le pH de la solution est ajusté à 4 par ajout d'acide acétique pour accroitre la solubilité des différents sels.

Cette solution est ensuite atomisée au moyen d'un atomiseur ultrasonique dont la fréquence d'excitation a été règlée pour donner des gouttelettes d'un diamètre moyen de 4,5 $\mu m$ environ.

Les fines gouttelettes de l'aérosol sont alors véhiculées pneumatiquement par de l'air (débit : 100 l/h), puis introduites dans un four permettant de faire passer rapidement leur température de l'ambiante à 850°C (la durée de montée en température est comprise entre 5 et 10 secondes).

Le traitement thermique à 850°C est maintenu pendant 5 secondes. Les particules résultantes sont récoltées sur un filtre électrostatique.

L'analyse aux rayons-X montre que l'on obtient une poudre homogène répondant à la formule Y - Ba$_2$ - Cu$_3$ - O$_{7-x}$ ($0 \leqq x \leqq 0,2$) en phase orthorhombique caractéristique des composés Y Ba Cu O supraconducteurs.

Cette poudre est constituée de particules quasiment sphériques dont les diamètres varient entre 0,3 $\mu m$ et 1,5 $\mu m$ en étant centrés sur un diamètre moyen de 0,7 $\mu m$ avec un écart-type de 0,3. Chaque particule est constituée de cristallites élémentaires dont la taille (déterminée par microscopie électronique à balayage) est inférieure à 100 nanomètres.

Un recuit sous oxygène à 850° C pendant deux heures permet d'accroitre la cristallisation. La taille des cristallites après recuit est alors voisine de 250 nanomètres.

La surface spécifique de la poudre, mesurée au moyen d'un porosimètre à mercure, est de l'ordre de 15 $m^2/g$.

Des mesures de susceptibilité de la poudre montrent que celle-ci est supraconductrice en dessous de la température critique de 93° K.

EXEMPLE 2

Comme l'exemple 1, cet exemple illustre l'invention dans le cadre de la préparation d'un matériau supraconducteur de formule Y - Ba$_2$ - Cu$_3$ - O$_{7-x}$ ($0 \leqq x \leqq 0,2$), mais avec des précurseurs différents.

On prépare une solution précurseur consistant en une solution aqueuse dans laquelle est dissous de l'acide citrique (0,13 mole/l), à base de carbonate d'yttrium (0,02 mole/l), de carbonate de baryum (0,08 mole/l) et d'acétate de cuivre (0,12 mole/l). Le pH de la solution est ajusté à 7 par ajout d'ammoniaque (NH$_4$OH) pour accroitre la stabilité des différents sels.

Cette solution est ensuite atomisée au moyen d'un atomiseur ultrasonique et l'aérosol amené dans un four dans les conditions décrites pour l'exemple 1. L'aérosol est alors porté en quelques secondes à 850° C puis maintenu à cette température pendant au moins 2 secondes. Les particules résultantes sont récupérées sur un électrofiltre.

L'analyse aux rayons-X montre que l'on obtient une poudre homogène répondant à la formule $Y - Ba_2 - Cu_3 - O_{7-x}$ ($0 \leq x \leq 0,2$) en phase orthorhombique. Cette poudre est constituée de particules quasiment sphériques dont les diamètres varient entre 0,4 µm et 3 µm en étant centrés sur un diamètre moyen de 1,5 µm avec un écart type de 0,4.

Chaque particule est constituée de cristallites élémentaires dont la taille (déterminée par microscopie électronique à balayage) est inférieure à 100 nanomètres. Un recuit sous $O_2$ à 850° C pendant 2 heures permet d'accroître la taille des cristallites à une valeur voisine de 250 nanomètres. Des mesures de susceptibilité magnétique de la poudre montrent que la poudre est supraconductrice en dessous de la température critique de 93 K.

EXEMPLE 3

Comme les exemples 1 et 2, cet exemple illustre à nouveau l'invention dans le cadre de la préparation d'un matériau supraconducteur de formule $Y - Ba_2 - Cu_3 - O_{7-x}$ ($0 \leq x \leq 0,2$), mais à partir de précurseurs différents.

On prépare une solution précurseur consistant en une solution aqueuse, à base d'acétate d'yttrium (0,02 mole/l), d'acétate de baryum (0,04 mole/l) et d'acétate de cuivre (0,06 mole/l). Le pH de la solution est ajusté à 4 par ajout d'acide acétique pour accroître la stabilité des différents sels.

Cette solution est ensuite atomisée au moyen d'un atomiseur ultrasonique et l'aérosol amené dans un four dans les conditions décrites pour l'exemple 1. L'aérosol est alors porté en quelques secondes à 850° C puis maintenu à cette température pendant au moins 2 secondes. Les particules résultantes sont récupérées sur un électrofiltre.

L'analyse aux rayons-X montre que l'on obtient une poudre homogène répondant à la formule $Y - Ba_2 - Cu_3 - O_{7-x}$ avec $0 \leq x \leq 0,2$ en phase orthorhombique.

Cette poudre est constituée de particules quasiment sphériques dont les diamètres varient entre 0,3 µm et 2,5 µm en étant centrés sur un diamètre moyen de 0,8 µm avec un écart-type de 0,35.

Chaque particule est constituée de cristallites élémentaires dont la taille (déterminée par microscopie électronique à balayage) est inférieure à 100 nanomètres.

Un recuit sous oxygène à 800° C pendant deux heures permet d'accroître la taille des cristallites à une valeur voisine de 250 nanomètres. Des mesures de susceptibilité magnétique de la poudre obtenue montrent que cette dernière est supraconductrice en dessous de la température critique de 93 K.

**Revendications**

1/ Procédé de préparation d'une poudre fine supraconductrice essentiellement à base d'au moins une terre rare, d'au moins un alcalino-terreux, d'au moins un métal de transition et d'oxygène, caractérisé en ce qu'il consiste à traiter thermiquement un aérosol contenant, sous la forme de sels organiques et/ou inorganiques et/ou sous la forme d'hydroxydes, ladite terre rare, ledit alcalino-terreux et ledit métal de transition dans un rapport correspondant à la stoechiométrie de la composition supraconductrice désirée.

2/ Procédé selon la revendication 1 caractérisé en ce que la phase liquide dudit aérosol est une phase aqueuse.

3/ Procédé selon l'une quelconque des revendications précédentes caractérisé en ce que ledit aérosol est obtenu au moyen d'un atomisateur ultrasonique.

4/ Procédé selon l'une quelconque des revendications précédentes caractérisé en ce que ledit traitement thermique est réalisé à une température d'au moins 700° C.

5/ Procédé selon la revendication 4 caractérisé en ce que ledit traitement thermique est réalisé à une température d'au moins 850°C.

6/ Procédé selon l'une quelconque des revendications 4 à 5 caractérisé en ce que la durée dudit traitement thermique est comprise entre 1 seconde et 30 minutes.

7/ Procédé selon la revendication 6 caractérisé en ce que ladite durée est comprise entre 5 et 15 secondes.

8/ Procédé selon l'une quelconque des revendications précédentes caractérisé en ce que ledit traitement thermique est effectué sous air.

9/ Procédé selon l'une quelconque des revendications précédentes caractérisé en ce que la poudre issue dudit traitement thermique est soumise à un traitement de recuit réalisé à une température comprise entre 400 et 1000° C.

10/ Procédé selon la revendication 9 caractérisé en ce que ledit traitement de recuit est réalisé à une température voisine de 850° C.

11/ Procédé selon l'une quelconque des revendications 9 et 10 caractérisé en ce que ledit traitement de recuit est réalisé sous oxygène.

12/ Procédé selon l'une quelconque des revendications précédentes caractérisé en ce que l'on utilise des sels inorganiques et/ou organiques.

13/ Procédé selon la revendication 12 caractérisé en ce que lesdits sels inorganiques sont choisis parmi les nitrates et les carbonates.

14/ Procédé selon la revendication 12 caractérisé en ce que lesdits sels organiques sont des sels d'acides aliphatiques saturés.

15/ Procédé selon la revendication 14 caractérisé en ce que lesdits sels organiques sont choisis parmi les formiates, les acétates et les propionates.

16/ Procédé selon la revendications 15 caractérisé en ce que les sels organiques sont des acétates.

17/ Procédé selon l'une quelconque des revendications précédentes caractérisé en ce que la terre rare est choisie parmi l'yttrium, le lantane et l'erbium.

18/ Procédé selon l'une quelconques des revendications précédentes caractérisé en ce que l'alcalino-terreux est choisi parmi le baryum, le strontium et le calcium.

19/ Procédé selon l'une quelconque des revendications précédentes caractérisé en ce que le métal de transition est le cuivre.

20/ Procédé selon l'une quelconque des revendications précédentes caractérisé en ce que la terre rare est l'yttrium, l'alcalino-terreux est le baryum, et le métal de transition est le cuivre.

21/ Poudre céramique supraconductrice essentiellement à base d'au moins une terre rare, d'au moins un alcalino-terreux, d'au moins un métal de transition et d'oxygène, caractérisée en ce qu'elle est constituée de particules quasi sphériques dont la taille est centrée sur un diamètre moyen compris entre 0,1 et 2 microns avec un écart-type standart inférieur ou égal à 1,4.

22/ Poudre selon la revendication 21 caractérisée en ce que lesdites particules sont constituées de cristallites élémentaires de taille comprise entre 100 et 500 nanomètres.

23/ Poudre selon la revendication 22 caractérisée en ce que ladite taille de cristallites élémentaires se situe aux environs de 250 nanomètres.

24/ Poudre céramique selon l'une quelconque des revendications 21 à 23 caractérisée en ce qu'elle répond à la formule : $Y - Ba_2 - Cu_3 - O_{7-x}$ avec $0 \leqq x \leqq 0,2$

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| D,Y | J. AM. CHEM. SOC., vol. 109, no. 8, 15 avril 1987, pages 2528-2530, American Chemical Society, A.M. STACY et al.: "High-temperature superconductivity in Y-Ba-Cu-O: Identification of a copper-rich superconducting phase" * Page 2528, colonne de droite, alinéa 3 * | 1-24 | C 01 G    3/00 H 01 L   39/24 H 01 L   39/12 |
| Y | FR-A-2 024 178  (U.K.A.E.) * Revendications 1-4 * | 1-24 | |
| A | DE-A-3 409 815  (SIEMENS) * Revendications 1,3 * | 3 | |
| A | ADVANCED CERAMIC MATERIALS- CERAMIC SUPERCONDUCTORS, vol. 2, no. 3B, juillet 1987, pages 444-456, ACerS, Westerville, OH, US; G.W. CRABTREE et al.: "Fabrication, mechanical properties, heat capacity, oxygen diffusion, and the effect of alkali earth ion substitution on high Tc superconductors" * Page 449, alinéas 1,2 * | 18 | |
| P,X | APPL. PHYS. LETT., vol. 52, no. 19, 9 mai 1988, pages 1622-1624, American Insitute of Physics; T.T. KODAS et al.: "Aerosol flow reactor production of fine Y1Ba2Cu3O7 powder: Fabrication of superconducting ceramics" * En entier *          -/- | 1-24 | |

**DOMAINES TECHNIQUES RECHERCHES (Int. Cl.4)**

C 01 G    3/00
C 04 B   35/00
H 01 L   39/00
B 01 J    2/00
C 01 B   13/00

Le présent rapport a été établi pour toutes les revendications

| Lieu de la recherche | Date d'achevement de la recherche | Examinateur |
|---|---|---|
| LA HAYE | 14-06-1989 | ZALM W.E. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié a date de dépôt ou après cette date
D : cité dans la demande
L : cité pour d'autres raisons

      & : membre de la même famille, document correspondant

EPO FORM 1503 03.82 (P0402)

**Office européen**
**des brevets**

# RAPPORT DE RECHERCHE EUROPEENNE

Numero de la demande

EP  89 40 0522

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| P,X | MAT. RES. BULL., vol. 23, 1988, pages 1337-1344, Pergamon Press Plc; A. PEBLER et al.: "Synthesis of small particle size YBa2Cu3O7-x by a vapor phase process" * En entier * | 1-24 | |
| P,X | MODERN PHYSICS LETTERS B, vol. 2, no. 1, 1988, pages 501-504, World Scientific Publishing Co.; S. SHIMAZU et al.: "Preparation of Ba2YCu3O7-x by spray decomposition method" * En entier * | 1-24 | |
| E | WO-A-8 902 8/.   (MERCK) * En entier * | 1-24 | |

DOMAINES TECHNIQUES RECHERCHES (Int. Cl.4)

Le présent rapport a été établi pour toutes les revendications

| Lieu de la recherche | Date d'achèvement de la recherche | Examinateur |
|---|---|---|
| LA HAYE | 14-06-1989 | ZALM W.E. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-ecrite
P : document intercalaire

T : théorie ou principe à la base de l'invention
E : document de brevet antérieur. mais publié à la date de dépôt ou après cette date
D : cité dans la demande
L : cité pour d'autres raisons

.................................................................
& : membre de la même famille. document correspondant

EPO FORM 1503 03 82 (P0802)